# EUROPÄISCHE PATENTSCHRIFT

(11) **EP 0 939 976 B1**
(45) Veröffentlichungstag und Bekanntmachung des Hinweises auf die Patenterteilung: **20.03.2002**
(21) Anmeldenummer: 97951792.7
(22) Anmeldetag: 20.11.1997
(51) Int. Cl.: H01R 13/645, H05K 7/14, H01R 12/18

(54) **EINRICHTUNG ZUR CODIERUNG VON STECKPLÄTZEN**
DEVICE FOR CODING PLUG RECEPTACLES
DISPOSITIF DE CODAGE DE PRISES DE FICHES

(30) Priorität: 22.11.1996 DE 29620410 U
(43) Veröffentlichungstag der Anmeldung: 08.09.1999
(73) Patentinhaber: SIEMENS AKTIENGESELLSCHAFT, 80333 München (DE)
(72) Erfinder: ABERT, Michael, D-76474 Au (DE); BALZER, Kurt, D-76767 Hagenbach (DE); MORLOCK, Siegfried, D-75196 Remchingen (DE)
(86) Internationale Anmeldenummer: DE9702725
(87) Internationale Veröffentlichungsnummer: WO9824153

(56) Entgegenhaltungen:
- CH-A- 586 962
- CH-A- 607 542
- DE-A- 4 420 984
- US-A- 4 579 412
- US-A- 4 595 250

## Beschreibung

Die Erfindung betrifft eine Einrichtung zur Codierung von Steckplätzen nach dem Oberbegriff des Anspruchs 1.

Aus der DE 43 23 440 A1 ist eine Einrichtung zum Anschluß externer Leitungen an eine speicherprogrammierbare Steuerung bekannt, die zur Signalübertragung mit dieser gekoppelt und räumlich unabhängig von der speicherprogrammierbaren Steuerung aufstellbar ist. Die Anschlußeinrichtung erlaubt einen modularen Aufbau, bei dem je Aktor-/Sensoranschluß eine Anschlußstelle vorhanden ist, die dem jeweiligen Anschlußtyp entsprechend mit einem elektronischen Modul zur Signalumsetzung versehen werden kann. Ein- und Ausgabemodule sind dabei beliebig mischbar. Dies wirkt sich vorteilhaft auf die Projektierung, Montage, Fehlerbeseitigung oder Erweiterung des elektronischen Geräts aus. Die Anschlußeinrichtung fungiert gleichzeitig als Trägereinheit für die elektronischen Module und weist eine Vielzahl gleichartiger Steckplätze für diese auf. Versorgungs- und Signalleitungen werden den elektronischen Modulen jeweils über einen Steckverbinder am Steckplatz zugeführt. Es können elektronische Module mit verschiedenen Betriebsspannungen, z. B. 230 V Wechselspannung oder 24 V Gleichspannung, eingesetzt werden. Ihre Verdrahtung über den Steckverbinder am Steckplatz erleichtert zwar den Austausch elektronischer Module, erhöht aber gleichzeitig die Gefahr einer Verwechslung. Dies kann zu Problemen führen, da nach erfolgter Verdrahtung der Einrichtung zum Anschluß externer Leitungen der jeweilige, an einem Steckplatz zu bestückende Typ des elektronischen Moduls, insbesondere seine Versorgungsspannung, festgelegt ist.

Aus der US-PS 4 595 250 ist eine Einrichtung zur Codierung von Steckplätzen in einer Trägereinheit für elektronische Module bekannt, bei welcher die elektronischen Module eine seitlich hervorstehende Kante und die Steckplätze zu den Kanten korrespondierende Einführschlitze aufweisen. Zur Codierung der Steckplätze sind drehbare Glieder mit radial gegenüber der Drehachse versetzten Zapfen vorgesehen, deren Lage zu Öffnungen an einem elektronischen Modul korrespondieren muß, damit dieses in den Steckplatz einsteckbar ist.

Der Erfindung liegt die Aufgabe zugrunde, eine Einrichtung zur Codierung von Steckplätzen zu schaffen, durch die verhindert wird, daß elektronische Module in Steckplätze eingesetzt werden, für die sie nicht geeignet sind.

Zur Lösung dieser Aufgabe weist die neue Einrichtung der eingangs genannten Art die im kennzeichnenden Teil des Anspruchs 1 angegebenen Merkmale auf. In den Unteransprüchen 2 bis 4 sind vorteilhafte Weiterbildungen der erfindungsgemäßen Einrichtung beschrieben. Mit Anspruch 5 wird Schutz für eine Trägereinheit oder ein Modul beansprucht, das zur Verwendung bei der neuen Einrichtung zur Codierung der Steckplätze ausgebildet ist.

Die Erfindung hat den Vorteil, daß neben Trägereinheit und elektronischen Modulen für die Codierung keinerlei zusätzliche Teile benötigt werden. Der Codierschieber ist fest an der Trägereinheit angebracht und kann somit nicht beim Transport oder der Inbetriebnahme der Einrichtung zum Anschluß externer Leitungen verloren werden. An den elektronischen Modulen ist lediglich eine Ausnehmung zur Codierung vorgesehen, die je nach Modultyp bereits bei der Herstellung angebracht wird und keinen zusätzlichen Aufwand bedeutet. Bei einer geänderten Verdrahtung der Einrichtung zum Anschluß externer Leitungen kann die Stellung des Schiebers leicht angepaßt werden, so daß der Vorteil der freien Mischbarkeit elektronischer Module in den Steckplätzen der Trägereinheit auch nach Änderungen erhalten bleibt. Wenn der Schieber nur mit einem Werkzeug verstellbar ist, sind versehentliche Manipulationen im Umgang mit der Trägereinheit ausgeschlossen. Vorteilhaft ist eine Stellung des Codierschiebers, in der kein Modul in den jeweiligen Steckplatz einsteckbar ist. Im Auslieferzustand befinden sich alle Codierschieber der Trägereinheit in dieser Stellung. Dadurch wird sichergestellt, daß der Codierschieber vom Anwender nach der Verdrahtung bewußt in Übereinstimmung mit der gewählten Verdrahtung gebracht werden muß. Danach kann nur der jeweils richtige Modultyp in die Steckplätze gesteckt werden. In vorteilhafter Weise benötigt die Einrichtung zur Codierung der Steckplätze keinerlei störende, aus der Trägereinheit hervorstehende Teile, wenn die Zapfen in Einführschlitze an den Steckplätzen hineinragen.

Zur Erhöhung der Codevarianten an einem Steckplatz können Codierschieber mit einer Vielzahl von Raststellungen oder mehrere Codierschieber für einen Steckplatz verwendet werden, die eine Vielzahl von Kombinationsmöglichkeiten bieten.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
- Figur 1: eine Trägereinheit,
- Figur 2: einen Ausschnitt aus Figur 1 mit einem Codierschieber in vergrößerter Darstellung,
- Figur 3: ein elektronisches Modul für Gleichspannungsversorgung und
- Figur 4: ein elektronisches Modul für eine Versorgung mit Wechselspannung.

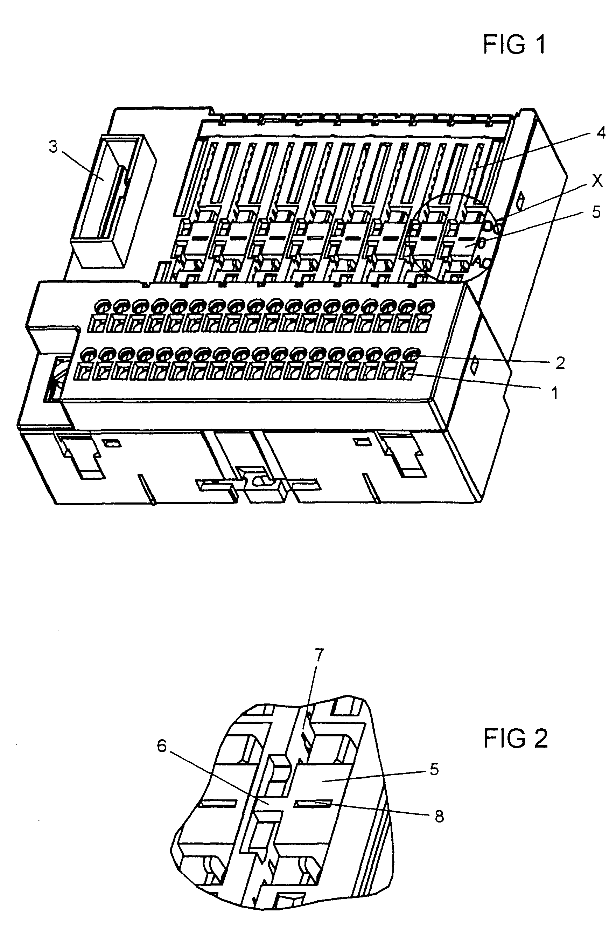

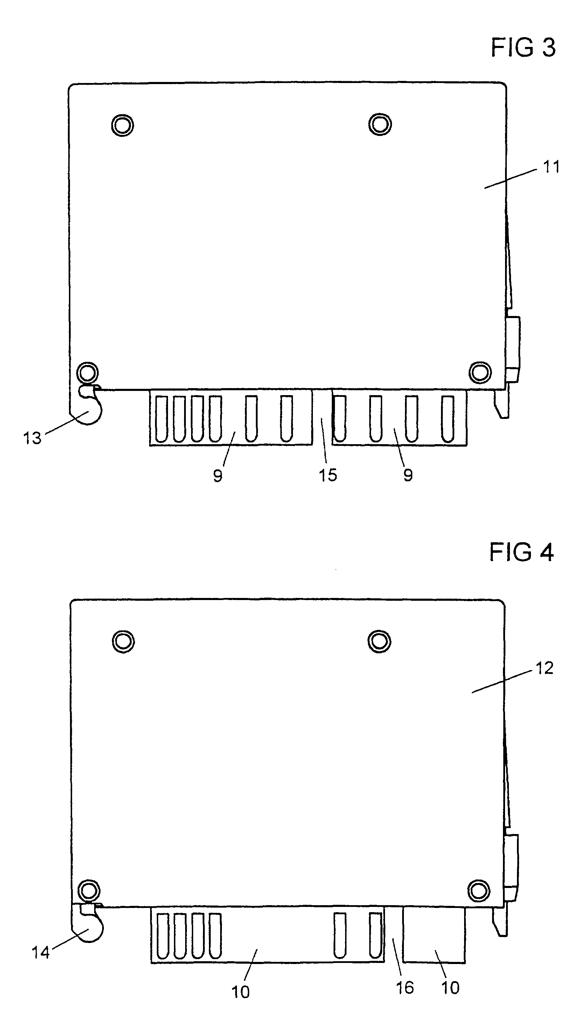

Eine Trägereinheit gemäß Figur 1 dient als Einrichtung zum Anschluß externer Leitungen und ist hierzu an ihrer Vorderseite mit zwei Reihen von Anschlußklemmen versehen. Durch Öffnungen 1 werden abisolierte Leitungsenden in Anschlußklemmen eingelegt, die über Betätigungsöffnungen 2 durch ein Werkzeug lösbar sind. Über einen Kabelanschluß 3 kann die Anschlußeinrichtung mit einer entfernten Steuerung, z. B. einem Personalcomputer oder einem Automatisierungsgerät, die über eine geeignete Kommunikationsschnittstelle verfügen, gekoppelt werden. Zur Umsetzung der Signalart auf den angeschlossenen externen Leitungen sind elektronische Module in acht Steckplätze einsetzbar, die an der Vorderseite der Trägereinheit im oberen Teil nebeneinander angeordnet sind. Der rechte Steckplatz ist mit dem Bezugszeichen 4 versehen. Die elektronischen Module haben einheitliche äußere Abmessungen und sind daher beliebig gegeneinander tauschbar. Über die Steckplätze werden den elektronischen Modulen sowohl die Signalleitungen als auch die Leitungen zu ihrer Stromversorgung zugeführt. Vor der Verdrahtung der zu den einzelnen Steckplätzen gehörenden Anschlußklemmen ist die an einem Steckplatz anliegende Betriebsspannung noch nicht festgelegt. Nach der Verdrahtung ist der Modultyp, mit dem ein Steckplatz bestückt werden kann, jedoch vorbestimmt und muß mit einem Codierschieber 5 eingestellt werden. Im Auslieferzustand befindet sich der Codierschieber 5 in einer Stellung "0", in der kein elektronisches Modul in den Steckplatz eingesetzt werden kann. Je nach Verdrahtung wird der Codierschieber 5 auf eine Stellung "DC" oder eine Stellung "AC" umgelegt, in welcher lediglich ein Modul mit Gleichspannungsversorgung gemäß Figur 3 bzw. ein Modul mit Wechselspannungsversorgung entsprechend Figur 4 einsetzbar ist. Damit wird verhindert, daß Module mit einer 24-V-Gleichspannung auf Steckplätze gesteckt werden, die mit 230 V Wechselspannung verdrahtet sind und umgekehrt.

Figur 2 zeigt den Codierschieber 5 in vergrößerter Darstellung. Mit einem Zapfen 6 ragt der Codierschieber 5 in einen Einführschlitz 7 hinein, in dem Federkontakte zur Kontaktierung von Kontaktflächen eines elektronischen Moduls untergebracht sind. An der Oberseite des Codierschiebers 5 befindet sich ein Schlitz 8, in den eine Schraubendreherklinge zum Ändern der Steckplatzcodierung eingesetzt werden kann. Die Abmessungen des Codierschiebers und seiner Umgebung sowie die zum Verstellen erforderlichen Kräfte sind so bemessen, daß eine Stellungsänderung ohne Zuhilfenahme eines Werkzeugs nicht möglich ist. Dadurch werden versehentliche Manipulationen ausgeschlossen.

Wie in den Figuren 3 und 4 gezeigt, bestehen elektronische Module im wesentlichen aus einer bestückten Leiterplatte 9 bzw. 10, die in einem Gehäuse 11 bzw. 12 untergebracht ist und dieses an der Seite, mit der es in Einführschlitze der Trägereinheit eingesetzt wird, seitlich überragt. Zum Einsetzen in die in Figur 1 gezeigte Trägereinheit werden die elektronischen Module mit einem Gelenkzapfen 13 bzw. 14 an der Oberkante der Trägereinheit eingehängt und nach unten geschwenkt, so daß die Seitenkanten der Leiterplatte 9 bzw. 10 mit auf ihrer Oberseite befindlichen Kontaktflächen eine Steckverbindung mit Kontaktfedern in den Einführschlitzen herstellen. Damit ein elektronisches Modul für Gleichspannungsversorgung nur in einen entsprechend verdrahteten Steckplatz eingesetzt werden kann, ist die Seitenkante mit einer zur Position des Zapfens 6 in der Stellung "DC" des Codierschiebers 5 korrespondierenden Ausnehmung 15 versehen. In entsprechender Weise ist eine Ausnehmung 16 an dem in Figur 4 dargestellten Modul für Wechselspannungsversorgung so plaziert, daß dieses Modul nur in einen Steckplatz eingesetzt werden kann, an dem sich der Codierschieber in der Stellung "AC" befindet.

Obwohl in dem Ausführungsbeispiel die Erfindung anhand einer Einrichtung zum Anschluß externer Leitungen als Trägereinheit und Umsetzmodulen als elektronische Module für die Steckplätze der Trägereinheit beschrieben wurde, ist die Erfindung auch bei beliebigen anderen Trägereinheiten zur Codierung von Steckplätzen geeignet. Beispielsweise kann sie zur Codierung der Steckplätze von Baugruppen in einem Baugruppenträger oder von Steckplätzen für Frontstecker an einer mit Ein- oder Ausgabebaugruppen bestückten speicherprogrammierbaren Steuerung verwendet werden.

## Patentansprüche

1. Einrichtung zur Codierung von Steckplätzen in einer Trägereinheit für elektronische Module, wobei elektronische Module vorgesehen sind, die eine seitlich hervorstehende Kante (9, 10) aufweisen, und wobei die Steckplätze zu den Kanten (9, 10) korrespondierende Einführschlitze (7) aufweisen, **dadurch gekennzeichnet, daß** an der Trägereinheit für jeden Steckplatz (4) zumindest ein in mehreren Stellungen rastbarer Codierschieber (5) mit einem Zapfen (6) vorgesehen ist, wobei der Zapfen (6) in den jeweiligen Einführschlitz (7) hineinragt, so daß nur diejenigen Module an dem jeweiligen Steckplatz einsteckbar sind, die eine zur jeweiligen Stellung des Codierschiebers (5) korrespondierende Ausnehmung (15, 16) für den Zapfen (6) aufweisen.

2. Einrichtung nach Anspruch 1, **dadurch gekennzeichnet, daß** der Codierschieber (5) nur mit einem Werkzeug verstellbar ist.

3. Einrichtung nach Anspruch 1 oder 2, **dadurch gekennzeichnet, daß** der Codierschieber (5) eine Stellung "0" aufweist, in der kein Modul in den jeweiligen Steckplatz (4) einsteckbar ist.

4. Einrichtung nach einem der vorhergehenden Ansprüche, **dadurch gekennzeichnet,**
- **daß** die elektronischen Module als Baugruppen ausgebildet sind,
- **daß** die seitlich hervorstehenden Kanten (9, 10) mit Kontaktflächen versehene Leiterplattenkanten (9, 10) sind und
- **daß** die Einführschlitze (7) mit Kontaktfedern versehen sind.

5. Trägereinheit für eine Einrichtung nach einem der vorhergehenden Ansprüche, **dadurch gekennzeichnet, daß** Steckplatze für elektronische Module vorgesehen sind,
- daß die Steckplätze zu den Kanten (9, 10) der Module korrespondierende Einführschlitze (7) aufweisen,
- daß an der Trägereinheit für jeden Steckplatz (4) zumindest ein in mehreren Stellungen rastbarer Codierschieber (5) mit einem Zapfen (6) vorgesehen ist, wobei der Zapfen (6) in den jeweiligen Einführschlitz (7) hineinragt, so daß nur diejenigen Module an dem jeweiligen Steckplatz einsteckbar sind, die eine zur jeweiligen Stellung des Codierschiebers (5) korrespondierende Ausnehmung (15, 16) für den Zapfen (6) aufweisen.

6. Elektronisches Modul für eine Einrichtung nach einem der Ansprüche 1 bis 4, **dadurch gekennzeichnet,**
- **daß** das elektronische Modul eine seitlich hervorstehende, zu den Einführschlitzen (7) der Steckplätze einer Trägereinheit korrespondierende Kante (9, 10) mit einer Ausnehmung (15, 16) für den Zapfen (6) eines Codierschiebers der Trägereinheit aufweist.

## Claims

1. Device for coding module slots in a chassis unit for electronic modules, wherein electronic modules which have a laterally projecting edge (9, 10) are provided and wherein the module slots have entry slots (7) corresponding to the edges (9, 10), **characterised in that** at least one coding slider (5) with a peg (6), which can be locked in several positions, is provided on the chassis unit for each module slot (4), wherein the peg (6) projects into the respective entry slot (7) so that only those modules which have a corresponding cut-out (15, 16) for the peg (6) can be inserted into the respective module slot.

2. Device according to Claim 1, **characterised in that** the coding slider (5) can be adjusted only with a tool.

3. Device according to Claim 1 or 2, **characterised in that** the coding slider (5) has a "0" position in which no module can be inserted into the respective module slot (4).

4. Device according to one of the preceding Claims, **characterised in that**
- the electronic modules are constructed as assemblies,
- the laterally projecting edges (9, 10) are printed circuit board edges (9, 10) provided with contact surfaces, and
- the entry slots (7) are provided with contact springs.

5. Chassis unit for a device according to one of the preceding Claims, **characterised in that**
- module slots are provided for electronic modules,
- the module slots have entry slots (7) corresponding to the edges (9, 10) of the modules,
- at least one coding slider (5) with a peg (6), which can be locked in several positions, is provided on the chassis unit for each module slot (4), wherein the peg (6) projects into the respective entry slot (7) so that only those modules which have a corresponding cut-out (15, 16) for the peg (6) can be inserted into the respective module slot.

6. Electronic module for a device according to one of Claims 1 to 4, **characterised in that**
- the electronic module has a laterally projecting edge (9, 10) with a cut-out (15, 16) for the peg (6) of a coding slider of the chassis unit, said edge corresponding to the entry slots (7) of the module slots of a chassis unit.

## Revendications

1. Dispositif de codage de prises d'enfichage dans un ensemble unitaire de support destiné à des modules électroniques, dans lequel sont prévus des modules électroniques comportant un bord (9, 10) saillant latéralement, et dans lequel les prises d'enfichage présentent des fentes d'introduction (7) coïncidant avec lesdits bords (9, 10), **caractérisé par le fait qu'**au moins un curseur de codage (5), muni d'un tenon (6) et encliquetable dans plusieurs positions, est prévu sur l'ensemble unitaire de support pour chaque prise d'enfichage (4), ledit tenon (6) pénétrant, dans la fente d'introduction (7) considérée, de façon telle que seuls puissent être emboîtés, sur la prise d'enfichage respective, les modules qui comportent un évidement (15, 16) destiné au tenon (6) et coïncidant avec la position considérée du curseur de codage (5).

2. Dispositif selon la revendication 1, **caractérisé par le fait que** le curseur de codage (5) ne peut être réglé qu'à l'aide d'un outil.

3. Dispositif selon la revendication 1 ou 2, **caractérisé par le fait que** le curseur de codage (5) présente une position "O" dans laquelle aucun module ne peut être emboîté dans la prise d'enfichage (4) considérée.

4. Dispositif selon l'une des revendications précédentes, **caractérisé par le fait**
- **que** les modules électroniques sont réalisés sous la forme de groupes structurels,
- **que** les bords (9, 10) saillant latéralement sont des bords (9, 10) de plaques à circuits imprimés, pourvus de surfaces de contact, et
- **que** les fentes d'introduction (7) sont dotées de ressorts de contact.

5. Ensemble unitaire de support pour un dispositif selon l'une des revendications précédentes, **caractérisé par le fait**
- **que** des prises d'enfichage sont prévues pour des modules électroniques,
- **que** lesdites prises d'enfichage comportent des fentes d'introduction (7) coïncidant avec les bords (9, 10) des modules,
- **qu'**au moins un curseur de codage (5), muni d'un tenon (6) et encliquetable dans plusieurs positions, est prévu sur l'ensemble unitaire de support pour chaque prise d'enfichage (4), ledit tenon (6) pénétrant, dans la fente d'introduction (7) considérée, de façon telle que seuls puissent être emboîtés, sur la prise d'enfichage respective, les modules qui comportent un évidement (15, 16) destiné au tenon (6) et coïncidant avec la position considérée du curseur de codage (5).

6. Module électronique pour un dispositif selon l'une des revendications 1 à 4, **caractérisé par le fait**
- **que** ledit module électronique présente un bord (9, 10) saillant latéralement, coïncidant avec les fentes d'introduction (7) des prises d'enfichage d'un ensemble unitaire de support, et pourvu d'un évidement (15, 16) pour le tenon (6) d'un curseur de codage dudit ensemble unitaire de support.
